# EUROPEAN PATENT SPECIFICATION

(11) **EP 4 156 374 B1**
(45) Date of publication and mention of the grant of the patent: **29.07.2026**
(21) Application number: 21845484.1
(22) Date of filing: 15.06.2021
(51) Int. Cl.: H01M 10/42, G01R 31/28, H04L 12/40

(54) **SLAVE BMS, MASTER BMS, AND BATTERY PACK FOR DIAGNOSING CAUSE OF COMMUNICATION ERROR**
SLAVE-BMS, MASTER-BMS UND BATTERIEPACK ZUR DIAGNOSE DER URSACHE EINES KOMMUNIKATIONSFEHLERS
BMS ESCLAVE, BMS MAÎTRE, ET BLOC-BATTERIE DESTINÉ À DIAGNOSTIQUER UNE CAUSE D'ERREUR DE COMMUNICATION

(30) Priority: 24.07.2020 KR 20200092272
(43) Date of publication of application: 29.03.2023
(73) Proprietor: LG Energy Solution, Ltd., Seoul 07335 (KR)
(72) Inventor: YANG, Seong Yeol, Daejeon 34122 (KR); CHUNG, Moon Koo, Daejeon 34122 (KR)
(74) Representative: Hoffmann Eitle
(86) International application number: PCT/KR2021/007495
(87) International publication number: WO 2022/019481

(56) References cited:
- JP-A- 2001 186 581
- JP-A- 2020 065 138
- JP-A- 2020 065 138
- KR-A- 20130 045 600
- KR-A- 20130 045 600
- KR-A- 20140 078 323
- KR-A- 20190 048 673
- KR-A- 20190 048 673

## Description

### [Technical Field]

This application claims priority to and the benefit of Korean Patent Application No. 10-2020-0092272 filed in the Korean Intellectual Property Office on July 24, 2020.

### TECHNICAL FIELD

The present invention relates to a battery pack, and more particularly, to a battery pack for diagnosing a cause of a communication error.

### [Background Art]

Recently, research and development of secondary batteries have been actively carried out. Herein, the secondary batteries, which are chargeable/dischargeable batteries, may include all of the recent lithium-ion batteries such as conventional nickel/cadmium (Ni/Cd) batteries, nickel-metal hydride (Ni/MH) batteries, etc. Among the secondary batteries, a lithium-ion battery advantageously has a much higher energy density than those of the conventional Ni/Cd batteries, Ni/MH batteries, etc. Moreover, the lithium-ion battery may be manufactured in a small size and a lightweight, such that the lithium-ion battery has been used as a power source of mobile devices. In addition, the lithium-ion battery has been gaining attention as a next-generation energy storage medium due to its extended range of use to a power source of electric vehicles.

Furthermore, the secondary battery is generally used as a battery pack including a battery module where a plurality of battery cells is connected in series and/or in parallel. The state and operation of the battery pack are managed and controlled by the battery management system.

A battery system including a plurality of battery packs may include a master BMS and a plurality of slave BMSs. The master BMS may control operations of the plurality of slave BMSs by communicating with a high-level system. In this case, the master BMS may transmit a command signal to each of the plurality of slave BMSs through communication.

The master BMS may receive data from each of the plurality of slave BMSs. The received data may include information related to a battery managed by each slave BMS. The master BMS may determine the state of each slave BMS, based on the data received from each slave BMS. However, when the master BMS fails to receive data from a particular slave BMS in the determination of a state of the slave BMS, it may be difficult to identify whether such an error is caused by a problem of communication or a problem of the slave BMS.
KR 2019 0048673 A relates to a battery management system (BMS) includes a master controller 1000, a slave controller group 2000, a bus line 3000, and a battery cell group 4000.

### [Disclosure]

### [Technical Problem]

Therefore, the present invention has been made in view of the above problems, and it is an object of the present invention to provide a battery pack for diagnosing whether a cause of a communication error is a problem in communication or problem of a slave BMS when an error and/or loss occurs in data received from the slave BMS.

### [Technical Solution]

In view of the above, the present invention proposes a slave battery management system, a battery pack and master battery management system as defined by the appended claims.

A slave battery management system (BMS) according to an aspect includes a communication circuit, a signal generation circuit, and an output terminal. The communication circuit may output a result of monitoring a first battery module to an external device. The signal generation circuit may generate a state signal having a first pattern in a first state and generate the state signal having a second pattern that is different from the first pattern in a second state. The output terminal may output the state signal to a second slave BMS.

A battery pack according to an aspect includes a first battery module and a first slave BMS. The first slave BMS may output a result of monitoring a first battery module to an external device through a first communication link. The first slave BMS may output a state signal having a first pattern to a second slave BMS in a first state and output the state signal having a second pattern that is different from the first pattern to the second slave BMS through a second communication link in a second state.

A master BMS according to an embodiment of the present invention includes a communication circuit and a controller. The communication circuit may communicate with a first slave BMS and a second slave BMS. A controller may determine based on a notification signal received from the second slave BMS whether an error is caused by an internal problem of the first slave BMS or a problem of communication between the communication circuit and the first slave BMS, when the error occurs in communication with the first slave BMS.

### [Advantageous Effects]

A first slave BMS according to an embodiment of the present invention may generate a state signal having a different pattern according to a state of the first slave BMS. A second slave BMS that is adjacent to the first slave BMS may transmit information about the state of the first slave BMS to a master BMS, based on the state signal of the first slave BMS. Therefore, the master BMS according to an embodiment of the present invention may determine whether an error occurring in data received from the first slave BMS is caused by a problem of communication between the master BMS and the first slave BMS or a problem of the first slave BMS, when the error occurs in the received data.

### [Description of Drawings]

FIG. 1 is a block diagram schematically showing a battery control system including a battery pack 1 and a high-level controller 2 included in a high-level system, according to an embodiment of the present invention.
FIG. 2 is a simplified structural diagram of a conventional slave BMS inspection system.
FIG. 3 is a simplified structural diagram of a slave BMS inspection system, according to an embodiment of the present invention.
FIG. 4 is a flowchart illustrating a method of diagnosing a cause of an error of data output from a slave BMS 35 of FIG. 3.
FIG. 5 is a flowchart illustrating a method of diagnosing a cause of an error of data output from a slave BMS 38 of FIG. 3.
FIG. 6 is a conceptual diagram for showing the slave BMS 35 of FIG. 3.
FIG. 7 is a flowchart for describing an operation of the slave BMS 35 of FIG. 6.
FIG. 8 is a flowchart for describing an operation of the slave BMS 35 of FIG. 6.
FIG. 9 is a conceptual diagram for describing a configuration of the master BMS 30 of FIG. 3.
FIG. 10 is a view showing a hardware configuration of a BMS according to an embodiment of the present invention.

### [Mode for Invention]

Hereinafter, various embodiments of the present invention will be described with reference to the accompanying drawings. In this document, the same reference numerals are used for the same components in the drawings, and a redundant description of the same components may be omitted.

For various embodiments of the present invention disclosed in this document, specific structural or functional descriptions are only exemplified for the purpose of describing the embodiments of the present invention, and various embodiments of the present invention may be implemented in various forms, and should not be construed as being limited to the embodiments described in this document.

As used in various embodiments, the terms "1^{st}", "2^{nd}", "first", "second", or the like may modify various components regardless of importance, and do not limit the components. For example, a first component may be named as a second component without departing from the right scope of the present invention, and similarly, the second component may be named as the first component.

Terms used in the present document are used for only describing a specific exemplary embodiment of the invention and may not have an intention to limit the scope of other exemplary embodiments of the invention. It is to be understood that the singular forms include plural references unless the context clearly dictates otherwise.

All of the terms used herein including technical or scientific terms have the same meanings as those generally understood by an ordinary skilled person in the related art. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In some cases, the terms defined **herein** may be interpreted to exclude embodiments of the present invention.

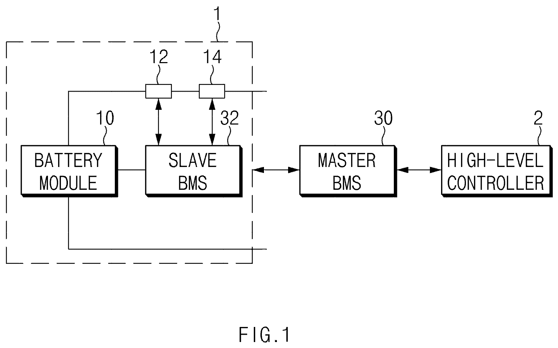

FIG. 1 is a block diagram schematically showing a battery control system including a battery pack 1 and a high-level controller 2 included in a high-level system, according to an embodiment of the present invention.

As shown in FIG. 1, the battery pack 1 may include a battery module 10 including one or more battery cells and is chargeable/dischargeable, a switching unit 14 connected in series to a positive (+) terminal side or a negative (-) terminal side of the battery module 10 to control a charging/discharging current flow of the battery module 10, and a slave battery management system (BMS) 32 for control and management to prevent overcharging, over-discharging, etc., by monitoring the voltage, current, temperature, etc., of the battery pack 1.

Herein, as the switching unit 14 which is a semiconductor switching element for controlling a current flow for charging or discharging of the battery module 10, for example, at least one metal-oxide-semiconductor field-effect transistor (MOSFET) may be used.

The slave BMS 32 may measure or calculate a voltage and a current of a gate, a source, a drain, etc., of the semiconductor switching element to monitor the voltage, current, temperature, etc., of the battery pack 1, and measure the current, voltage, temperature, etc., of the battery pack 1 by using a sensor 12 provided adjacent to the semiconductor switching element. The slave BMS 32, which is an interface for receiving measurement values of the above-described various parameters, may include a plurality of terminals and a circuit, etc., connected thereto to process input values.

The slave BMS 32 may control on/off of the MOSFET and may be connected to the battery module 10 to monitor the state of the battery module 10.

Such configurations of the battery pack 1 and the slave BMS 32 are well-known configurations, and thus will not be described in detail.

Meanwhile, the slave BMS 32 according to embodiments of the present invention may be connected to a master BMS 30 and may be controlled in an operation thereof based on a signal applied from a high-level BMS. The master BMS 30 may also be connected with the high-level controller 2. The master BMS 30 may also be controlled in terms of an operation thereof based on a signal applied from the high-level controller 2.

Hereinbelow, a description will be made of a configuration and a method for evaluating a state of health (SOH) of a slave BMS that transmits data to the master BMS 30 that directly receives a control signal from the high-level controller 2.

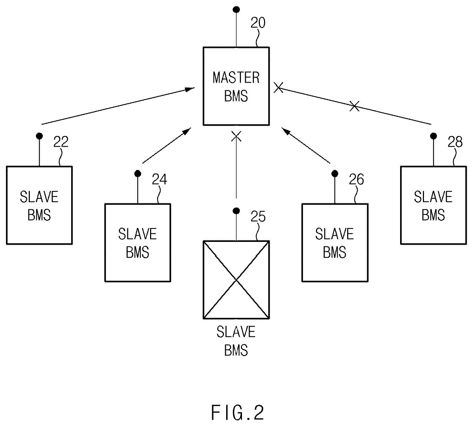

FIG. 2 is a simplified structural diagram of a conventional slave BMS inspection system.

The slave BMS inspection system may include a master BMS 20 and slave BMSs 22 through 28. The master BMS 20 may directly receive an operation control command signal for each slave BMS from the high-level controller 2 to control each slave BMS. The master BMS 20 may also receive battery-related data from each of the slave BMSs 22 through 28 to transmit the same to the high-level controller 2.

Moreover, the slave BMSs 22 through 28 having received a control signal from the master BMS 20 may operate according to the received control signal. For example, the slave BMSs 22- 28 may control charging/discharging of battery modules managed respectively or transmit data regarding states of the battery modules monitored respectively to the master BMS 20. Thereafter, each of the slave BMSs 22- 28 may transmit data for inspecting the state of the connected battery module 10 to the master BMS 20, according to the control signal or periodically.

When the master BMS 20 and the slave BMSs 22- 28 communicate with each other, a communication link between the master BMS and the slave BMSs may become unstable depending on a surrounding environment. Even when the slave BMSs 22- 28 operate normally, the master BMS 20 may erroneously determine the SOH of the slave BMSs 22 through 28 due to instability of the communication link.

Each of the slave BMSs 22- 28 may transmit data related thereto, e.g., data regarding the battery module managed by each slave BMS to the master BMS 20.

For example, as shown in FIG. 2, the master BMS 20 may receive data from the first, second, and fourth slave BMSs 22, 24, and 28. However, the master BMS 20 may not receive data from the third and fifth slave BMSs 26 and 28. In this case, the third slave BMS 26 may fail to transmit data to the master BMS 20 due to a problem in the BMS itself. On the other hand, data transmitted by the fifth slave BMS 28 may fail to arrive at the master BMS 20 due to an error in communication with the master BMS 20 even when the fifth slave BMS 28 does not have a problem therein.

In this way, with a conventional communication method, the master BMS 20 may not be able to distinguish a case where the slave BMS fails to receive data due to a problem therein from a case where the slave BMS fails to receive data due to a problem of a communication state despite no problem in the slave BMS. Therefore, with a conventional technique, the SOH of the slave BMS may not be accurately inspected. The present invention conceived to supplement such points will be described in detail below.

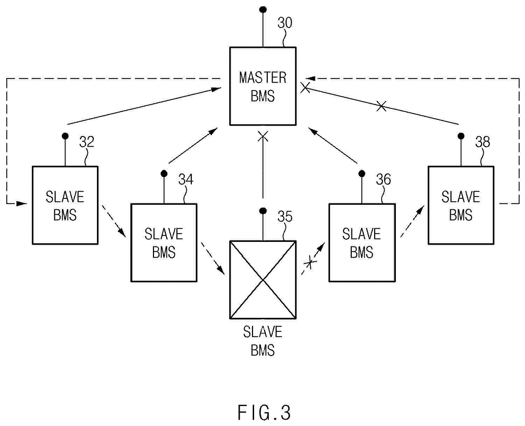

FIG. 3 is a simplified structural diagram of a slave BMS inspection system, according to an embodiment of the present invention.

A slave BMS inspection system 3 may include a master BMS 30 and slave BMSs 32 through 38. In the present specification, a battery pack may include the slave BMSs 32 through 38 and battery modules monitored by the slave BMSs 32 through 38. However, the battery pack may include slave BMSs that are more than or less than those shown in FIG. 3

The master BMS 30 may communicate with each of the slave BMSs 32-38 through a communication link. In the present specification, the communication link may refer to any means connecting two points to transmit and receive data in a wired or wireless manner. For example, the master BMS 30 may communicate with each of the slave BMSs 32 -38 through a controller area network (CAN) bus.

As such, when the master BMS 30 and the slave BMSs 32 through 38 communicate with each other, the communication link between the master BM and the slave BMSs 32-38 may become unstable depending on a surrounding environment. In this case, a part of data output from the slave BMSs 32-38 may be lost or an error may occur in the output data.

Even in case of a problem in the slave BMSs 32 through 38 rather than a problem in the communication link, the part of the data output from the slave BMSs 32 through 38 may be lost or the error may occur in the output data.

According to an embodiment of the present invention, the slave BMS inspection system 3 may diagnose whether an error of data received in the master BMS 30 is caused by a problem of communication or a problem of a slave BMS. Related operations of the slave BMS inspection system 3 will be described in detail below.

Each of the slave BMSs 32 through 38 may transmit data to the master BMS 30. For example, the slave BMS 32 may transmit monitoring data regarding a battery module monitored by the slave BMS 32 to the master BMS 30.

Each of the slave BMSs 32- 38 may output its state signal to the next adjacent slave BMS in a certain direction. The first slave BMS may mean a slave BMS that is located first in the direction among the slave BMSs 32-38 and receives a state signal from the master BMS 30. The last slave BMS may mean a slave BMS that is located last in the direction and thus has no next adjacent slave BMS. When each of the slave BMSs 32 - 38 outputs its state signal to an adjacent slave BMS in the right direction, the first slave BMS and the last slave BMS may be the slave BMS 32 and the slave BMS 38, respectively.

The slave BMS 32 may receive the state signal of the master BMS 30 from the master BMS 30. The slave BMS 32 may generate its state signal based on the state signal of the master BMS 30. More specifically, based on characteristics (e.g., period, duty ratio, amplitude) of the state signal of the master BMS 30, the state signal of each of the slave BMSs 32 through 38 may be determined. For example, when the slave BMSs 32-38 are in a normal state, the state signal of each of the slave BMSs 32-38 may be the same as the state signal of the master BMS 30. In another example, when the slave BMSs 32-38 are in an abnormal state, the state signal of each of the slave BMSs 32-38 may be a voltage signal that increases or reduces a period of the state signal of the master BMS 30.

The state signal may be a voltage signal. The state signal may be a signal having a square wave pattern. In the present specification, when a signal has a different pattern, it may refer as the signal has a different period or a voltage signal has different amplitude or different duty ratio. However, the present invention is not limited thereto.

The slave BMS 32 may generate a state signal having a different pattern according to its state. For example, when the slave BMS 32 does not operate normally or an error occurs therein, the slave BMS 32 may generate a state signal having a first pattern. When the slave BMS 32 operates normally or an error does not occur therein, the slave BMS 32 may generate a state signal having a second pattern. The second pattern may be different from the first pattern. The slave BMS 32 may generate a state signal having a different pattern according to a type of an error occurring therein.

The slave BMS 32 may output the state signal to an adjacent slave BMS 34. The slave BMS 34 adjacent to the slave BMS 32 may receive the state signal of the slave BMS 32 from the slave BMS 32. In the present specification, the slave BMS 34 adjacent to the slave BMS 32 may mean a slave BMS located closest to the slave BMS 32 among the slave BMSs 34-38.

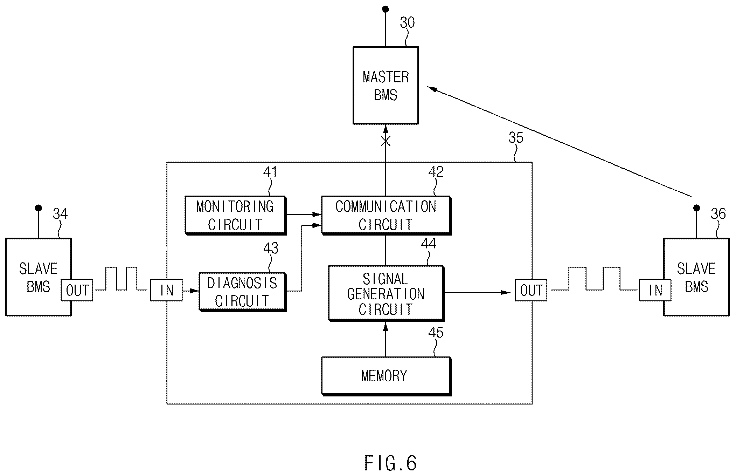

In this case, the slave BMS 32 may output monitoring data through a communication circuit, and may output a state signal by using a terminal that does not need a separate communication circuit. For example, the communication circuit may be a communication circuit that communicates with external devices based on a CAN network, and a communication terminal may be a pin or a terminal of a general-purpose input/output (GPIO). However, the present invention is not limited thereto, and the foregoing description will be made in detail with reference to FIG. 6.

The slave BMS 34 may diagnose the state of the slave BMS 32 based on a state signal. More specifically, the slave BMS 34 may diagnose whether an error occurs in the slave BMS 32, based on a pattern of the state signal. In addition, the slave BMS 34 may diagnose a type of error occurring in the slave BMS 32, based on the pattern of the state signal. The master BMS 30 and the slave BMSs 32-38 may previously store information about patterns of state signals. The master BMS 30 and the slave BMSs 32-38 may generate their state signals based on the previously stored information or diagnose a state of an adjacent BMS based on a received state signal.

The slave BMS 34 may output information about the state of the slave BMS 32 to the master BMS 30. For example, the slave BMS 34 may output information about the state of the slave BMS 32 through a CAN bus. The slave BMS 34 may use the CAN bus to output information about a battery module monitored by the slave BMS 34. That is, the slave BMS 34 may output the information about the battery module and the information about the state of the slave BMS 32, by using the same CAN bus.

The slave BMS 34 may output a notification signal to the master BMS 30 when an error occurs in the slave BMS 32. The notification signal may include information about the error occurring in the slave BMS 32.

Thus, when a loss and/or an error occur in data received from the slave BMS 35, the master BMS 30 may determine whether the loss and/or the error of the data is caused by a problem of the slave BMS 35 or a problem of communication.

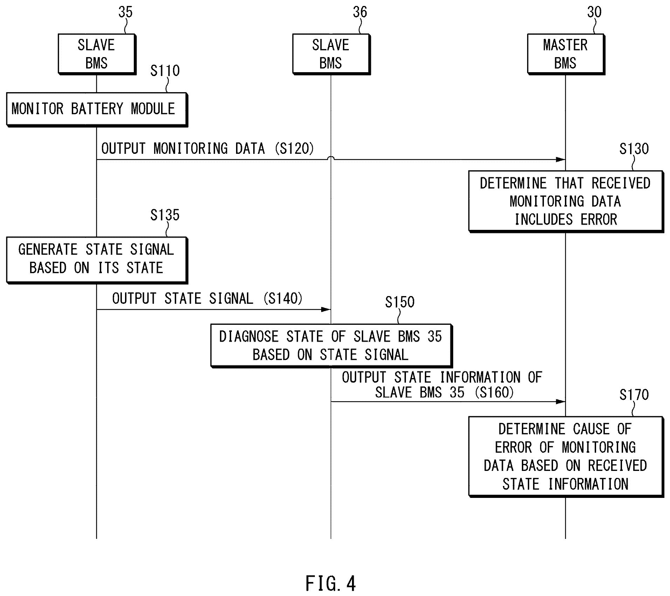

More specifically, the slave BMS 35 may output a state signal of a first pattern in a normal operation state. The slave BMS 35 may output a state signal of a second pattern in an abnormal operation state. Referring to FIG. 3, the slave BMS 35 may output the state signal of the second pattern to the slave BMS 36 because the slave BMS 35 operates abnormally. The slave BMS 36 may determine that an error occurs in the slave BMS 35 when the state of the second pattern is received. In this case, the slave BMS 36 may output information about the error of the slave BMS 35 to the master BMS 30. Based on the information about the error of the slave BMS 35, received from the slave BMS 36, the master BMS 30 may determine that the loss and/or the error of the data are caused by a problem of the slave BMS 35. Based on the determination, the master BMS 30 may take action such as controlling the slave BMS 35 or notify the high-level controller 2 of FIG. 1 of the state of the slave BMS 35. When the slave BMS 35 operates normally, the slave BMS 35 may notify the high-level controller 2 of FIG. 1 that an error occurs in a communication link. Such operations will be described in detail with reference to FIG. 4.

When a loss and/or an error occurs in data received from the last slave BMS (e.g., the slave BMS 38) among the slave BMSs 32-38, the master BMS 30 may diagnose whether the loss and/or the error of the data is caused by a problem of communication or a problem of the slave BMS 38, in the following manner.

The slave BMS 38 may output monitoring data regarding a battery module monitored by the slave BMS 38 to the master BMS 30. The slave BMS 38 may output the monitoring data to the master BMS 30 through a first path by using a communication circuit. The first path may be formed by the CAN bus, without being limited thereto.

The slave BMS 38 may output its state signal to the master BMS 30. The slave BMS 38 may output a state signal to the master BMS 30 through a second path by using a communication terminal. The second path may be a communication path generated through a GPIO pin of each of the slave BMS 38 and the master BMS 30, without being limited thereto.

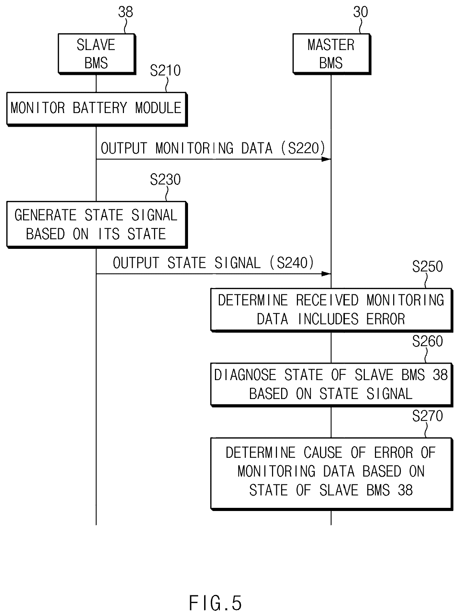

The master BMS 30 may diagnose the state of the slave BMS 38 based on the state signal received from the slave BMS 38. The master BMS 30 may determine based on the state signal of the slave BMS 38 whether an error of monitoring data received from the slave BMS 38 is caused by a problem of communication or a problem of the slave BMS 38. Such operations will be described in detail with reference to FIG. 5.

FIG. 4 is a flowchart for describing a method of diagnosing a cause of an error of data output from the slave BMS 35 of FIG. 3.

In operation S110, the slave BMS 35 of FIG. 3 may monitor a battery module. The slave BMS 35 may measure the voltage, current, temperature, etc., of the battery module to monitor the battery module.

In operation S120, the slave BMS 35 may output monitoring data to the master BMS 30. The monitoring data may be data about the battery module monitored by the slave BMS 35.

In operation S130, the master BMS 30 may receive the monitoring data from the slave BMS 35. The master BMS 30 may determine that the monitoring data includes an error.

In operation S135, the slave BMS 35 may generate a state signal based on its state. The state signal may have a different pattern according to the state of the slave BMS 35. The state of the slave BMS 35 may be related to whether the slave BMS 35 operates normally, whether the slave BMS 35 operates abnormally, and a type of error when the slave BMS 35 operates abnormally.

In operation S140, the slave BMS 35 may output the state signal to the slave BMS 36. The slave BMS 35 may output the state signal by using a communication terminal that is different from that used to output the monitoring data. The slave BMS 35 may output the state signal by using a communication path that is different from that used to output the monitoring data. This will be described in detail with reference to FIG. 6.

In operation S150, the slave BMS 36 may diagnose the state of the slave BMS 35 based on the state signal.

In operation S160, the slave BMS 36 may output state information about the state of the slave BMS 35 to the master BMS 30.

In operation S170, the master BMS 30 may determine a cause of an error of the monitoring data received from the slave BMS 35, based on the state information received from the slave BMS 36.

FIG. 5 is a flowchart for describing a method of diagnosing a cause of an error of data output from the slave BMS 38 of FIG. 3.

In operation S210, the slave BMS 38 of FIG. 3 may monitor a battery module. The slave BMS 38 may measure the voltage, current, temperature, etc., of the battery module to monitor the battery module.

In operation S220, the slave BMS 38 may output monitoring data to the master BMS 30. The monitoring data may be data about the battery module monitored by the slave BMS 38.

In operation S230, the slave BMS 38 may generate a state signal based on its state. The slave BMS 38 may output the state signal by using a communication terminal that is different from that used to output the monitoring data. The slave BMS 38 may output the state signal by using a communication path that is different from that used to output the monitoring data.

In operation S240, the slave BMS 38 may output the state signal to the master BMS 30.

In operation S250, the master BMS 30 may receive the monitoring data from the slave BMS 38. The master BMS 30 may determine that the monitoring data includes an error.

In operation S260, the master BMS 30 may receive the state signal from the slave BMS 38. The master BMS 30 may diagnose the state of the slave BMS 38 based on the state signal.

In operation S270, the master BMS 30 may identify a cause of the error of the monitoring data received from the slave BMS 38, based on the state information of the slave BMS 38.

FIG. 6 is a conceptual diagram for showing the slave BMS 35 of FIG. 3.

The slave BMS 35 may include a monitoring circuit 41, a communication circuit 42, a diagnosis circuit 43, a signal generation circuit 44, and a memory 45.

The monitoring circuit 41 may monitor a battery module connected to the slave BMS 35. The monitoring circuit 41 may monitor the battery module to generate monitoring data. The monitoring circuit 41 may output the monitoring data to the communication circuit 42.

The communication circuit 42 may output the monitoring data received from the monitoring circuit 41 to the master BMS 30. The communication circuit 42 may transmit and receive data to and from the master BMS 30 through a communication link. For example, the communication link may be a CAN bus.

The diagnosis circuit 43 may receive a state signal indicating the state of the slave BMS 34 from the slave BMS 34. A pin IN of a GPIO of the slave BMS 35 may be connected to a pin OUT of a GPIO of the slave BMS 34. The diagnosis circuit 43 may be connected to the pin IN of the GPIO. The diagnosis circuit 43 may receive the state signal of the slave BMS 34 through the pin IN of the GPIO. A pin IN of a GPIO of the slave BMS 34 may be connected to the pin OUT of the GPIO of the slave BMS 34.

The diagnosis circuit 43 may diagnose the state of the slave BMS 34 based on the state signal of the slave BMS 34. Referring to FIG. 6, the slave BMS 34 may be in the normal operation state. More specifically, the diagnosis circuit 43 may diagnose the state of the slave BMS 34 based on a period, a duty ratio, an amplitude, etc., of the state signal of the slave BMS 34. In the following description, when patterns of state signals are different from one another, it may mean that at least one of periods, duty ratios, and amplitudes of the state signals are different. For example, referring to FIG. 6, the slave BMS 34 may output a state signal corresponding to the normal operating state, and the slave BMS 35 may output a state signal corresponding to an abnormal operation state. A period of the state signal corresponding to the abnormal operating state may be longer than that of the state signal corresponding to the normal operating state.

The diagnosis circuit 43 may output state information about the state of the slave BMS 34 to the communication circuit 42. The communication circuit 42 may output the state information received from the diagnosis circuit 43 to the master BMS 30.

The signal generation circuit 44 may generate a state signal based on the state of the slave BMS 35. The memory 45 may store information about a state signal previously defined between the master BMS 30 and the slave BMS 35. The information about the state signal may define as a period, a duty ratio, an amplitude, etc., of the state signal corresponding to the state of the slave BMS 35. The diagnosis circuit 43 may also diagnose the state of the slave BMS 34 based on the state signal of the slave BMS 34, by using information stored in the memory 45.

The signal generation circuit 44 may generate a state signal based on the information stored in the memory 45. The signal generation circuit 44 may generate a different state signal according to the state whether the slave BMS 35 operates normally or abnormally. The signal generation circuit 44 may also generate a different state signal according to a type of an error occurring in the slave BMS 35.

The signal generation circuit 44 may output a state signal to an adjacent BMS through a pin OUT of a GPIO.

A pin OUT of a GPIO of the slave BMS 35 may be connected to a pin IN of a GPIO of an adjacent BMS. The adjacent BMS may receive the state signal through a pin IN of a GPIO thereof.

The slave BMS 35 may use additional communication network and/or communication line to transmit and receive state signals to and from the adjacent slave BMSs 34 and 36. The slave BMS 35 may communicate with the adjacent slave BMSs 34 and 36 by using a communication network that is different from that used to transmit and receive monitoring data to and from the master BMS 30. Thus, even when a communication network with the master BMS 30 or the communication circuit 42 has a problem, the slave BMS 35 may communicate with the slave BMS 36 and transmit information about its state to the slave BMS 36. In the present specification, when a communication network is different, it may mean that a communication line, a communication path, and a communication protocol are different.

The present invention may produce the slave BMS 35 according to the present invention more cheaply by implementing the slave BMS 35 to communicate with the adjacent slave BMSs 34 and 36 by using a GPIO of a communication line. The present invention may produce the slave BMS 35 more cheaply by implementing not only the slave BMS 35, but also the other slave BMSs 32, 34, 36, and 38 of FIG. 3 and the master BMS 30 to communicate with adjacent BMSs by using a GPIO.

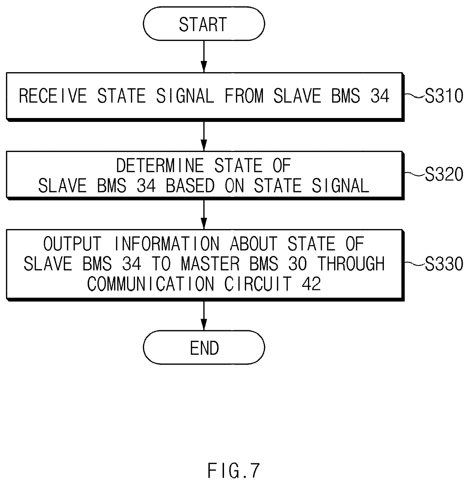

FIG. 7 is a flowchart for describing an operation of the slave BMS 35 of FIG. 6.

As described with reference to FIG. 6, operations of the slave BMS 35 may largely include an operation of outputting state information of the slave BMS 34 to the master BMS 30 by diagnosing the state of the adjacent slave BMS 34 and an operation of generating a state signal based on its state and outputting the state signal to another adjacent slave BMS 36. Referring to FIG. 7, a description will be made of an operation in which the slave BMS 35 diagnoses the state of the adjacent slave BMS 34 to output state information of the slave BMS 34 to the master BMS 30.

In operation S310, the slave BMS 35 may receive a state signal of the slave BMS 34 through a communication terminal.

In operation S320, the slave BMS 35 may diagnose the state of the slave BMS 34 based on the state signal of the slave BMS 34.

In operation S330, the slave BMS 35 may output state information about the state of the slave BMS 34 to the master BMS 30 through the communication circuit 42.

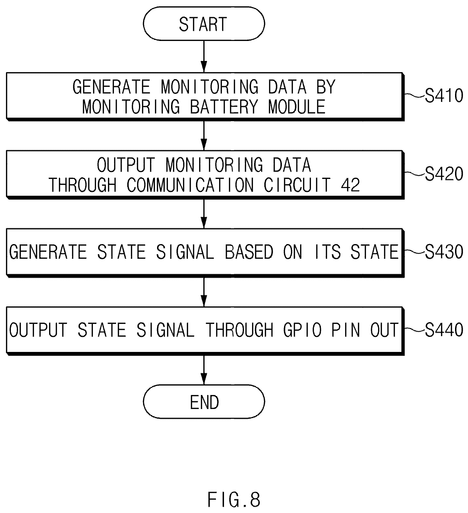

FIG. 8 is a flowchart for describing an operation of the slave BMS 35 of FIG. 6. Referring to FIG. 8, a description will be made of an operation in which the slave BMS 35 generates a state signal based on its state to output the generated state signal to another adjacent slave BMS 36.

In operation S410, the slave BMS 35 may generate monitoring data by monitoring a battery module.

In operation S420, the slave BMS 35 may output the monitoring data to the master BMS 30 through the communication circuit 42 by monitoring the battery module.

In operation S430, the slave BMS 35 may generate a state signal based on its state.

In operation S440, the slave BMS 35 may output the state signal to the slave BMS 36 through a GPIO pin OUT.

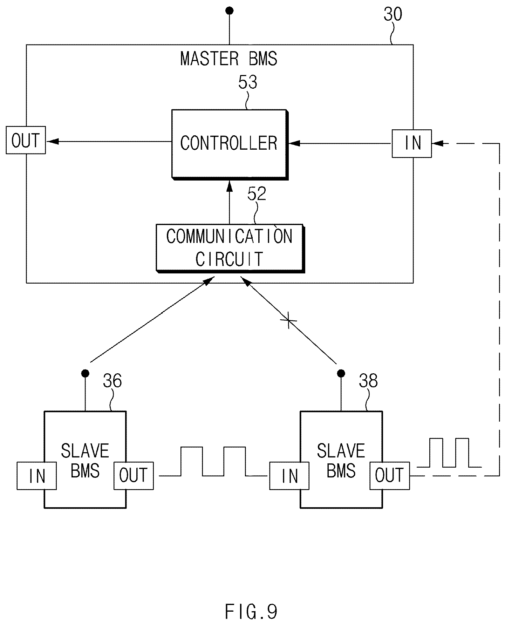

FIG. 9 is a conceptual diagram for describing a configuration of the master BMS 30 of FIG. 3.

The master BMS 30 may include communication terminals IN and OUT, a communication circuit 52, and a controller 53.

The master BMS 30 may transmit and receive data to and from the adjacent slave BMSs 36 and 38 of FIG. 3 through the communication terminals IN and OUT. For example, the master BMS 30 may communicate with the slave BMS 36 through a pin OUT of a GPIO and with the slave BMS 38 through a pin IN of the GPIO. More specifically, the master BMS 30 may receive a state signal of the slave BMS 38 through a pin IN of a GPIO connected to a pin OUT of the GPIO of the slave BMS 38.

The controller 53 may receive a state signal of the slave BMS 38 through the pin IN of the GPIO. The controller 53 may diagnose the state of the slave BMS 38 based on the state signal of the slave BMS 38.

The communication circuit 52 may receive monitoring data regarding a battery module monitored by the slave BMS 38 from the slave BMS 38.

The controller 53 may receive the monitoring data from the communication circuit 52. The controller 53 may determine whether the monitoring data includes an error. When the error occurs in the monitoring data, the controller 53 may diagnose based on the state signal of the slave BMS 38 whether the error is caused by a problem of the slave BMS 38, by a problem of communication between the master BMS 30 and the slave BMS 38, by a problem of a communication circuit of the slave BMS 38, etc.

When the monitoring data received from the slave BMS 36 includes an error, the master BMS 30 may diagnose a cause of the error of the data received from the slave BMS 36, based on state information received from the slave BMS 38 that is adjacent to the slave BMS 36. More specifically, the master BMS 30 may receive monitoring data from the slave BMS 36 through the communication circuit 52. The communication circuit 52 and communication circuits of slave BMSs communicating with the communication circuit 52 may communicate based on a CAN protocol by using a CAN bus. The controller 53 may diagnose the error of the monitoring data received through the communication circuit 52. The master BMS 30 may receive state information of the slave BMS 36 from the slave BMS 38 to diagnose the error of the monitoring data. In this case, the master BMS 30 may receive the state information of the slave BMS 36 through the communication circuit 52. The controller 53 may diagnose whether the error of the monitoring data is caused by the slave BMS 36, by a communication network, etc., based on the state information of the slave BMS 36, received through the communication circuit 52.

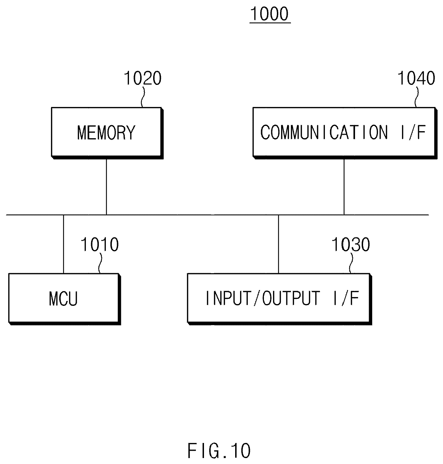

FIG. 10 is a view showing a hardware configuration of a BMS according to an embodiment of the present invention.

Referring to FIG. 10, a BMS 1000 may include a microcontroller unit (MCU) 1010 that performs various processing and control each component, a memory 1020 in which an operating system program and various programs (e.g., a battery diagnosis program, a voltage approximation formula calculation program, etc.) are recorded, an input/output interface (I/F) 1030 that provides an input interface and an output interface between a battery cell module and/or a semiconductor switching element, and a communication interface (I/F) 1040 that may communicate externally through a wired/wireless communication network. As such, a computer program according to the present invention may be recorded in the memory 1020 and processed by the microcontroller unit 1010, thus being implemented as a module that performs function blocks shown in FIGS. 6 and 9. More specifically, components of the BMS 1000 may be implemented as a module that implements a function of a slave BMS and/or a function of a master BMS in the present specification.

The foregoing description may include detailed embodiments for carrying out the present invention. The present invention may include not only the above-described embodiments, but also embodiments that may be simply design-changed or easily changed. In addition, the present invention may also include techniques that may be easily modified and carried out using the embodiments. Therefore, the scope of the present invention should be defined by the appended claims, rather than by the described embodiments.

## Claims

1. A first slave battery management system, BMS, (35) comprising:
a communication circuit (42) outputting a result of monitoring a first battery module to an external device (30);
a signal generation circuit (44) generating a state signal having a first pattern in a first state and generating the state signal having a second pattern that is different from the first pattern in a second state;
an output terminal outputting the state signal to a second slave BMS (36),
an input terminal receiving a state signal from a third slave BMS (34); and
a diagnosis circuit (43) diagnosing a state of the third slave BMS (34) based on a pattern of the state signal of the third slave BMS,
wherein the state of the third slave BMS (34) is output to the external device (30) through the communication circuit (42).

2. The first slave BMS (35) of claim 1, wherein the first state is a state where the first slave BMS (35) operates normally, and the second state is a state where the first slave BMS (35) does not operate normally.

3. The first slave BMS (35) of claim 2, wherein the state signal is a square wave signal, and
the state signal having the first pattern and the state signal having the second pattern are signals that are different from each other in terms of at least one of a period, a duty ratio, and an amplitude.

4. The first slave BMS (35) of claim 1, wherein the communication circuit (42) outputs the result through a controller area network, CAN, bus connected to the external device (30), and
the output terminal outputs the state signal through a terminal of a general-purpose input/output, GPIO, connected to a terminal of a GPIO of the second slave BMS.

5. A battery pack (1) comprising:
a first battery module; and
a first slave battery management system, ,BMS, (35) outputting a result of monitoring the first battery module to an external device (30) through a first communication link,
wherein the first slave BMS (35) outputs a state signal having a first pattern to a second slave BMS (36) in a first state and outputs the state signal having a second pattern that is different from the first pattern to the second slave BMS through a second communication link in a second state,
wherein the first slave BMS (35) further includes:
an input terminal receiving a state signal from a third slave BMS (34); and
a diagnosis circuit (43) diagnosing a state of the third slave BMS (34) based on a pattern of the state signal of the third slave BMS,
wherein the state of the third slave BMS (34) is output to the external device (30) through the communication circuit (42).

6. The battery pack (1) of claim 5, further comprising the second slave BMS (36) outputting a notification signal to the external device (30) through a third communication link, when it is diagnosed based on the state signal received through the second communication link that the first slave BMS (35) does not operate normally.

7. The battery pack of claim 6, wherein the external device is a master BMS (30) that controls the first slave BMS (32) and the second slave BMS,
the first communication link is generated by a controller area network, CAN, bus between the master BMS and the first slave BMS,
the second communication link is generated by the connection between a terminal of a general-purpose input/output, GPIO, of the first slave BMS and a terminal of a GPIO of the second slave BMS, and
the third communication link is generated by a CAN bus between the master BMS and the second slave BMS.

8. A master battery management system, BMS, (30) comprising:
a communication circuit (52)receiving a first notification signal notifying a state of a third slave BMS (34) from a first slave BMS (35) and receiving a second notification signal notifying a state of the first slave BMS (35) from a second slave BMS (36); and
a controller (53) determining based on the second notification signal received from the second slave BMS whether an error is caused by an internal problem of the first slave BMS or a problem of communication between the communication circuit and the first slave BMS, when the error occurs in communication with the first slave BMS.

9. The master BMS (30) of claim 8, wherein the communication circuit (52) receives information about a state of a first battery module monitored by the first slave BMS (35) from the first slave BMS (35) and receives the second notification signal indicating a state of the first slave BMS (35) from the second slave BMS (36).

10. The master BMS of claim 8, further comprising an input terminal receiving a state signal having a pattern that differs according to a state of the second slave BMS from the second slave BMS,
wherein the communication circuit (52) receives information about a state of a second battery module monitored by the second slave BMS from the second slave BMS,
the controller (53) determines based on a pattern of the state signal whether the error is caused by an internal problem of the second slave BMS or a problem of communication between the communication circuit and the second slave BMS, when the received information includes an error, and
the pattern of the state signal is related to at least one of a period, a duty ratio, and an amplitude of the state signal.

## Patentansprüche

1. Erstes Slave-Batteriemanagementsystem, BMS, (35), umfassend:
eine Kommunikationsschaltung (42), die ein Ergebnis der Überwachung eines ersten Batteriemoduls an eine externe Vorrichtung (30) ausgibt;
eine Signalerzeugungsschaltung (44), die in einem ersten Zustand ein Zustandssignal erzeugt, das ein erstes Muster aufweist, und die in einem zweiten Zustand das Zustandssignal erzeugt, das ein zweites Muster aufweist, das sich von dem ersten Muster unterscheidet;
einen Ausgangsanschluss, der das Zustandssignal an ein zweites Slave-BMS (36) ausgibt,
einen Eingangsanschluss, der ein Zustandssignal von einem dritten Slave-BMS (34) empfängt; und
eine Diagnoseschaltung (43), die einen Zustand des dritten Slave-BMS (34), basierend auf einem Muster des Zustandssignals des dritten Slave-BMS, diagnostiziert,
wobei der Zustand des dritten Slave-BMS (34) über die Kommunikationsschaltung (42) an die externe Vorrichtung (30) ausgegeben wird.

2. Erstes Slave-BMS (35) nach Anspruch 1, wobei der erste Zustand ein Zustand ist, in dem das erste Slave-BMS (35) normal arbeitet, und der zweite Zustand ein Zustand ist, in dem das erste Slave-BMS (35) nicht normal arbeitet.

3. Erstes Slave-BMS (35) nach Anspruch 2, wobei das Zustandssignal ein Rechtecksignal ist, und
das Zustandssignal, das das erste Muster aufweist, und das Zustandssignal, das das zweite Muster aufweist, Signale sind, die sich voneinander hinsichtlich zumindest einer von einer Periode, einem Tastverhältnis und einer Amplitude unterscheiden.

4. Erstes Slave-BMS (35) nach Anspruch 1, wobei die Kommunikationsschaltung (42) das Ergebnis über einen Controller-Area-Network-, CAN-, Bus ausgibt, der mit der externen Vorrichtung (30) verbunden ist, und
der Ausgangsanschluss das Zustandssignal über einen Anschluss einer Allgemeinzweck-Eingabe/Ausgabe, GPIO, ausgibt, die mit einem Anschluss einer GPIO des zweiten Slave-BMS verbunden ist.

5. Batteriepack (1), umfassend:
ein erstes Batteriemodul; und
ein erstes Slave-Batteriemanagementsystem, BMS, (35), das ein Ergebnis der Überwachung des ersten Batteriemoduls über eine erste Kommunikationsverbindung an eine externe Vorrichtung (30) ausgibt,
wobei das erste Slave-BMS (35) in einem ersten Zustand ein Zustandssignal, das ein erstes Muster aufweist, an ein zweites Slave-BMS (36) ausgibt und in einem zweiten Zustand das Zustandssignal, das ein zweites Muster aufweist, das sich von dem ersten Muster unterscheidet, an das zweite Slave-BMS über eine zweite Kommunikationsverbindung ausgibt,
wobei das erste Slave-BMS (35) weiter einschließt:
einen Eingangsanschluss, der ein Zustandssignal von einem dritten Slave-BMS (34) empfängt; und
eine Diagnoseschaltung (43), die einen Zustand des dritten Slave-BMS (34), basierend auf einem Muster des Zustandssignals des dritten Slave-BMS, diagnostiziert,
wobei der Zustand des dritten Slave-BMS (34) über die Kommunikationsschaltung (42) an die externe Vorrichtung (30) ausgegeben wird.

6. Batteriepack (1) nach Anspruch 5, weiter umfassend das zweite Slave-BMS (36), das ein Benachrichtigungssignal über eine dritte Kommunikationsverbindung an die externe Vorrichtung (30) ausgibt, wenn, basierend auf dem Zustandssignal, das über die zweite Kommunikationsverbindung empfangen wird, diagnostiziert wird, dass das erste Slave-BMS (35) nicht normal arbeitet.

7. Batteriepack nach Anspruch 6, wobei die externe Vorrichtung ein Master-BMS (30) ist, das das erste Slave-BMS (32) und das zweite Slave-BMS steuert,
die erste Kommunikationsverbindung durch einen Controller-Area-Network-, CAN-, Bus zwischen dem Master-BMS und dem ersten Slave-BMS erzeugt wird,
die zweite Kommunikationsverbindung durch die Verbindung zwischen einem Anschluss einer Allgemeinzweck-Eingabe/Ausgabe, GPIO, des ersten Slave-BMS und einem Anschluss einer GPIO des zweiten Slave-BMS erzeugt wird, und
die dritte Kommunikationsverbindung durch einen CAN-Bus zwischen dem Master-BMS und dem zweiten Slave-BMS erzeugt wird.

8. Master-Batteriemanagementsystem, BMS, (30) umfassend:
eine Kommunikationsschaltung (52), die ein erstes Benachrichtigungssignal, das einen Zustand eines dritten Slave-BMS (34) meldet, von einem ersten Slave-BMS (35) empfängt und die ein zweites Benachrichtigungssignal, das einen Zustand des ersten Slave-BMS (35) meldet, von einem zweiten Slave-BMS (36) empfängt; und
eine Steuereinheit (53), die, basierend auf dem zweiten Benachrichtigungssignal, das von dem zweiten Slave-BMS empfangen wird, bestimmt, ob ein Fehler durch ein internes Problem des ersten Slave-BMS oder ein Problem der Kommunikation zwischen der Kommunikationsschaltung und dem ersten Slave-BMS verursacht wird, wenn der Fehler in der Kommunikation mit dem ersten Slave-BMS auftritt.

9. Master-BMS (30) nach Anspruch 8, wobei die Kommunikationsschaltung (52) Informationen über einen Zustand eines ersten Batteriemoduls, das von dem ersten Slave-BMS (35) überwacht wird, von dem ersten Slave-BMS (35) empfängt und das zweite Benachrichtigungssignal, das einen Zustand des ersten Slave-BMS (35) angibt, von dem zweiten Slave-BMS (36) empfängt.

10. Master-BMS nach Anspruch 8, weiter umfassend einen Eingangsanschluss, der ein Zustandssignal, das ein Muster aufweist, das sich entsprechend einem Zustand des zweiten Slave-BMS unterscheidet, von dem zweiten Slave-BMS empfängt,
wobei die Kommunikationsschaltung (52) Informationen über einen Zustand eines zweiten Batteriemoduls, das von dem zweiten Slave-BMS überwacht wird, von dem zweiten Slave-BMS empfängt,
die Steuereinheit (53), basierend auf einem Muster des Zustandssignals, bestimmt, ob der Fehler durch ein internes Problem des zweiten Slave-BMS oder ein Problem der Kommunikation zwischen der Kommunikationsschaltung und dem zweiten Slave-BMS verursacht wird, wenn die empfangenen Informationen einen Fehler einschließen, und
das Muster des Zustandssignals mit mindestens einem von einer Periode, einem Tastverhältnis und einer Amplitude des Zustandssignals zusammenhängt.

## Revendications

1. Premier système de gestion de batterie (BMS) esclave (35), comprenant :
un circuit de communication (42) délivrant en sortie un résultat de surveillance d'un premier module de batterie vers un dispositif externe (30) ;
un circuit de génération de signal (44) générant un signal d'état présentant un premier motif dans un premier état et générant le signal d'état présentant un deuxième motif qui est différent du premier motif dans un deuxième état ;
une borne de sortie délivrant en sortie le signal d'état vers un deuxième BMS esclave (36),
une borne d'entrée recevant un signal d'état d'un troisième BMS esclave (34) ; et
un circuit de diagnostic (43) diagnostiquant un état du troisième BMS esclave (34) sur la base d'un motif du signal d'état du troisième BMS esclave,
dans lequel l'état du troisième BMS esclave (34) est délivré en sortie vers le dispositif externe (30) au moyen du circuit de communication (42).

2. Premier BMS esclave (35) selon la revendication 1, dans lequel le premier état est un état où le premier BMS esclave (35) fonctionne normalement, et le deuxième état est un état où le premier BMS esclave (35) ne fonctionne pas normalement.

3. Premier BMS esclave (35) selon la revendication 2, dans lequel le signal d'état est un signal d'onde carré, et
le signal d'état présentant le premier motif et le signal d'état présentant le deuxième motif sont des signaux qui diffèrent l'un de l'autre en termes d'au moins un parmi une période, un rapport cyclique, et une amplitude.

4. Premier BMS esclave (35) selon la revendication 1, dans lequel le circuit de communication (42) délivre en sortie le résultat au moyen d'un bus CAN (Controller Area Network, CAN) relié au dispositif externe (30), et
la borne de sortie délivre en sortie le signal d'état au moyen d'une borne d'une entrée/sortie à usage général (GPIO) reliée à une borne d'un GPIO du deuxième BMS esclave.

5. Bloc-batterie (1) comprenant :
un premier module de batterie ; et
un premier système de gestion de batterie (BMS) esclave (35) délivrant en sortie un résultat de surveillance du premier module de batterie vers un dispositif externe (30) au moyen d'une première liaison de communication,
dans lequel le premier BMS esclave (35) délivre en sortie un signal d'état présentant un premier motif vers un deuxième BMS esclave (36) dans un premier état et délivre en sortie le signal d'état présentant un deuxième motif qui est différent du premier motif vers le deuxième BMS esclave au moyen d'une deuxième liaison de communication dans un deuxième état,
dans lequel le premier BMS esclave (35) comporte en outre :
une borne d'entrée recevant un signal d'état d'un troisième BMS esclave (34) ; et
un circuit de diagnostic (43) diagnostiquant un état du troisième BMS esclave (34) sur la base d'un motif du signal d'état du troisième BMS esclave,
dans lequel l'état du troisième BMS esclave (34) est délivré en sortie vers le dispositif externe (30) au moyen du circuit de communication (42).

6. Bloc-batterie (1) selon la revendication 5, comprenant en outre le deuxième BMS esclave (36) délivrant en sortie un signal de notification vers le dispositif externe (30) au moyen d'une troisième liaison de communication, lorsqu'il est diagnostiqué sur la base du signal d'état reçu au moyen de la deuxième liaison de communication que le premier BMS esclave (35) ne fonctionne pas normalement.

7. Bloc-batterie selon la revendication 6, dans lequel le dispositif externe est un BMS maître (30) qui commande le premier BMS esclave (32) et le deuxième BMS esclave,
la première liaison de communication est générée par un bus CAN (Controller Area Network, CAN) entre le BMS maître et le premier BMS esclave,
la deuxième liaison de communication est générée par la liaison entre une borne d'une entrée/sortie à usage général (GPIO) du premier BMS esclave et une borne d'un GPIO du deuxième BMS esclave, et
la troisième liaison de communication est générée par un bus CAN entre le BMS maître et le deuxième BMS esclave.

8. Système de gestion de batterie (BMS) maître (30), comprenant :
un circuit de communication (52) recevant un premier signal de notification notifiant un état d'un troisième BMS esclave (34) provenant d'un premier BMS esclave (35) et recevant un deuxième signal de notification notifiant un état du premier BMS esclave (35) provenant d'un deuxième BMS esclave (36) ; et
un dispositif de commande (53) déterminant sur la base du deuxième signal de notification reçu du deuxième BMS esclave si une erreur est causée par un problème interne du premier BMS esclave ou un problème de communication entre le circuit de communication et le premier BMS esclave, lorsque l'erreur se produit dans la communication avec le premier BMS esclave.

9. BMS maître (30) selon la revendication 8, dans lequel le circuit de communication (52) reçoit des informations sur un état d'un premier module de batterie surveillé par le premier BMS esclave (35) provenant du premier BMS esclave (35) et reçoit le deuxième signal de notification indiquant un état du premier BMS esclave (35) provenant du deuxième BMS esclave (36).

10. BMS maître selon la revendication 8, comprenant en outre une borne d'entrée recevant, du deuxième BMS esclave, un signal d'état présentant un motif qui diffère selon un état du deuxième BMS esclave,
dans lequel le circuit de communication (52) reçoit des informations sur un état d'un deuxième module de batterie surveillé par le deuxième BMS esclave provenant du deuxième BMS esclave, le dispositif de commande (53) détermine sur la base d'un motif du signal d'état si l'erreur est causée par un problème interne du deuxième BMS esclave ou un problème de communication entre le circuit de communication et le deuxième BMS esclave, lorsque les informations reçues incluent une erreur, et
le motif du signal d'état est lié à au moins un parmi une période, un rapport cyclique, et une amplitude du signal d'état.
